**Europäisches Patentamt**

**European Patent Office**

**Office européen des brevets**

(11) Veröffentlichungsnummer : **0 337 331 B1**

(12) ## EUROPÄISCHE PATENTSCHRIFT

(45) Veröffentlichungstag der Patentschrift :
**21.10.92 Patentblatt 92/43**

(51) Int. Cl.⁵ : **H01B 7/08,** H01P 3/06,
H05K 3/46

(21) Anmeldenummer : **89106223.4**

(22) Anmeldetag : **08.04.89**

(54) **Verfahren zum Herstellen einer allseitig geschirmten Signalleitung.**

(30) Priorität : **14.04.88 DE 3812414**

(43) Veröffentlichungstag der Anmeldung :
**18.10.89 Patentblatt 89/42**

(45) Bekanntmachung des Hinweises auf die
Patenterteilung :
**21.10.92 Patentblatt 92/43**

(84) Benannte Vertragsstaaten :
**AT BE CH DE ES FR GB IT LI NL SE**

(56) Entgegenhaltungen :
**DE-A- 3 006 117**
**US-A- 4 673 904**

(73) Patentinhaber : **Standard Elektrik Lorenz
Aktiengesellschaft
Lorenzstrasse 10
W-7000 Stuttgart 40 (DE)**
(84) **DE**

Patentinhaber : **ALCATEL N.V.
Strawinskylaan 341 (World Trade Center)
NL-1077 XX Amsterdam (NL)**
(84) **BE CH ES FR GB IT LI NL SE AT**

(72) Erfinder : **Florjancic, Matjaz, Dr.
Staffelseeweg 9
W-7000 Stuttgart 50 (DE)**
Erfinder : **Smernos, Stauros, Dr.
Birkenwaldstrasse 127
W-7000 Stuttgart 1 (DE)**
Erfinder : **Richter, Horst, Dr.
Tiergartenstrasse 29
W-7030 Böblingen (DE)**
Erfinder : **Reiner, Hans, Prof.
Forchenrainstrasse 62
W-7016 Gerlingen (DE)**

(74) Vertreter : **Brose, Gerhard et al
Standard Elektrik Lorenz AG Patent- und
Lizenzwesen Postfach 30 09 29
W-7000 Stuttgart 30 (DE)**

**Beschreibung**

Die Erfindung betrifft ein Verfahren zum Herstellen einer allseitig geschirmten Signalleitung für Hochfrequenzschaltungen. Derartige allseitig geschirmte Signalleitungen sind z.B. Koaxialleitungen mit rechteckigem Querschnitt oder symmetrische allseitig geschirmte Triplateleitungen, wie sie zum Verbinden von Hoch- und Höchstfrequenzschaltungen, insbesondere in integrierten Mikrowellenschaltungen, verwendet werden.

Ein bekanntes Verfahren zum Herstellen von geschirmten Signalleitungen in Halbleiter-Hochfrequenzschaltungen (Proceedings of Electronic Components Conference, Washington, 1985, Seiten 384 bis 388, 386) weist neben anderen Verfahrensschritten im wesentlichen die Schritte a), b) und c) des Verfahrens nach Anspruch 1 auf. Nach dem Verfahrensschritt c) wird dort eine Prepregfolie unter Druck- und Wärmeeinwirkung auflaminiert. Das danach die Leiterbahnen abdeckende Isoliermaterial wird mechanisch entfernt. Eine solche mechanische Bearbeitung ist aber schwierig durchzuführen und erfordert einen hohen Aufwand.

Der Erfindung liegt die Aufgabe zugrunde, ein einfaches und zuverlässiges Verfahren zum Herstellen von allseitig geschirmten Signalleitungen bei Hoch- und Höchstfrequenzschaltungen zu schaffen, die ein Nebensprechen wirksam verhindern.

Diese Aufgabe wird erfinderungsgemäß durch ein Verfahren mit den Merkmalen von Patentanspruch 1 gelöst.

Vorteilhafte Weiterbildungen der Erfindung sind aus den Unteransprüchen ersichtlich.

Ein Ausführungsbeispiel der Erfindung wird im folgenden anhand der Zeichnung erläutert. Es zeigen:

Fig. 1 erfindungsgemäß hergestellte rechteckige Koaxialleitungen im Querschnitt und

Fig. 2A bis 2M die erfindungsgemäßen Verfahrenschritte in schematischer Darstellung.

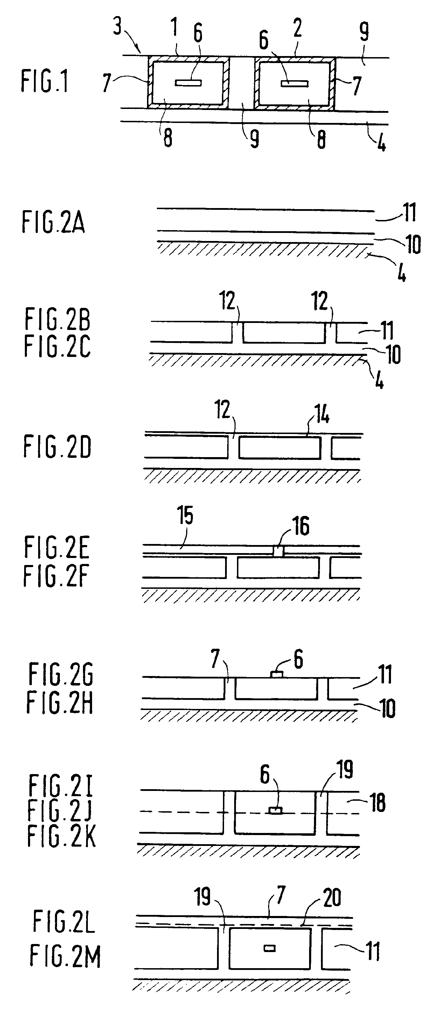

Zwei erfindungsgemäß hergestellte Signalleitungen 1 und 2 sind Bestandteil einer in der Zeichnung (Fig. 1) nur im Ausschnitt dargestellten, in Halbleitertechnik hergestellten Höchstfrequenzschaltung 3. Die Signalleitungen 1 und 2 sind als Rechteck-Koaxialleitungen ausgeführt, die auf einem gemeinsamen Träger 4 angeordnet sind.

Der Träger 4 ist z.B. aus einen glasfaserverstärktem Epoxidharz hergestellt. Die Signalleitungen 1, 2 weisen jeweils einen Innenleiter 6 und einen Außenleiter oder eine äußere Schirmwand 7 auf. Der Innenleiter 6 und der Außenleiter 7 sind aus einem gut leitenden Werkstoff, z.B. auf Kupfer, hergestellt.

Die inneren Hohlräume 8 der Signalleitungen 1, 2 und die Zwischenräume 9 zwischen den Signalleitungen 1 und 2 und sonstigen Schaltungsbestandteilen sind mit einem Dielekrtrikum aufgefüllt, der aus einem photostrukturierbaren Werkstoff, z.B. aus Epoxid oder Polyimid besteht. Diese mit Dielektrikum aufgefüllten Bereiche werden, wie noch anhand von Fig. 2 zu erläutern sein wird, mit Permanentresist-Folien, z.B. aus einem Lötstoppresist mit Endhärtung - hergestellt.

Die einzelnen Schritte des erfindungsgemäßen Verfahrens sind in Fig. 2 schematisch dargestellt, und zwar fortschreitend von oben nach unten. Sie sind in der Zeichnung mit den Buchstaben A bis M bezeichnet, die den Verfahrensschritten a) bis m) von Anspruch 1 entsprechen. Diese Buchstaben bezeichnen also die aufeinanderfolgenden Verfahrensschritte, nicht aber oder nur indirekt die einzelnen Werkstoffschichten.

Verfahrensschritt a):

Auf einen mit Kupfer kaschierten oder metallisierten Trägerwerkstoff 10 wird eine photostrukturierbare Folie 11 auflaminiert. Der Träger 4 besteht z.B. aus dem unter der Bezeichnung FR4 bekannten glasfaserverstärkten Kunststoff, die photostrukturierbare Folie 11 aus einem Permanentresist, z.B. aus einem Lötstoppfolienresist mit Endhärtung.

Verfahrensschritt b):

Die photostrukturierbare Folie 11 wird einem Photoprozeß unterworfen, der in bekannter Weise aus einem Belichten der zu verbleibenden Bereiche und aus einem nachfolgenden Entwicklungsvorgang besteht. Dabei werden Bereiche 12, die der Lage des Außenleiters 7 der fertigen Signalleitung 1 oder 2 entsprechen, abgetragen.

Verfahrensschritt c):

Die abgetragenen Bereiche 12 werden durch galvanische Abscheidung mit Kupfer aufgefüllt.

Verfahrensschritt d):

Auf die äußere in der Zeichnung obenliegende, Oberfläche der verbleibenden Bereiche der Folie 11 und der mit Kupfer aufgefüllten Außenleiter-Bereiche 12 wird durch chemisches Abscheiden von Kupfer eine dünne Leitschicht 14 aufgebracht. Diese Leitschicht 14 ist über die Bereich 12 mit der Kupferschicht 10 elektrisch leitend verbunden.

Verfahrensschritt e):

Auf die Leitschicht 14 wird eine Photoresistfolie 15 aufgebracht und durch einen erneuten Photoprozeß werden aus dieser Bereiche 16 abgetragen, die der Lage des Innenleiters 6 der Signalleitungen 1 oder 2 entsprechen.

Verfahrensschritt f);

Die Bereiche 16 werden durch galvanisches Abscheiden von Kupfer auf die für einen Signalleiter erforderliche Stärke gebracht.

Verfahrensschritt g):

Die verbleibenden Bereiche der Photoresistfolie werden abgestrippt, d.h. chemisch aufgelöst.

Verfahrensschritt h):

Die durch das Abstrippen der Photoresistfolie 15 offengelegte Leitschicht 14 wird durch eine Kupfer-Differenzätzung abgetragen. Damit ist die untere Hälfte der Außenleiter 7 hergestellt und der Innenleiter 6 von den anderen leitenden Bereichen, d.h. von dem Außenleiter 7, galvanisch getrennt.

Verfahrensschritt i):

Eine weitere photostrukturierbare Folie 18 wird auf die freigelegte Oberfläche auflaminiert. Dies ist in der Zeichnung durch eine gestrichelte linie angedeutet. Auch diese Folie 18 besteht aus einem Permanentresist, z.B. einem Lötstoppresist in Folienform.

Verfahrenschritt j):

Die Folie 18 wird in Bereichen 19, die dem oberen Teil des Außenleiters 7 entsprechen, durch einen weiteren Photoprozeß abgetragen.

Verfahrensschritt k):

Die abgetragenen Bereiche 19 werden durch galvanisches Abscheiden mit Kupfer aufgefüllt.

Verfahrensschritt l):

Auf die freie Oberfläche der verbleibenden Folie 18 und der mit Kupfer aufgefüllten Bereiche 19 wird durch chemisches Abscheiden von Kupfer eine dünne Leitschicht 20 aufgebracht.

Verfahrensschritt m):

Schließlich wird auf diese Leitschicht 20 galvanisch solange Kupfer abgeschieden, bis auch hier die erforderliche Wandstärke des Außenleiters 7 erreicht ist.

Damit ist das Verfahren abgeschlossen. In einem einzigen Herstellungsprozeß können eine oder mehrere allseitig geschirmte Signalleitungen für Hochfrequenzschaltungen gleichzeitig hergestellt werden. Mechanische Bearbeitungsschritte kommen bei diesem Verfahren nicht vor.

**Patentansprüche**

1. Verfahren zum Herstellen einer allseitig geschirmten Signalleitung (1,2) für Hochfrequenzschaltungen, das folgende Verfahrensschritte aufweist:

a) auf einer metallisierten Trägerschicht (10) wird eine photostrukturierbare Folie (11) auflaminiert,
b) diese Folie (11) wird in den Bereichen (12), die dem Außenleiter (7) der Signalleitung entsprechen, durch einen Photoprozeß abgetragen,
c) diese abgetragenen Bereiche (12) werden mit galvanisch abgeschiedenem Kupfer aufgefüllt,
d) auf die äußere Oberfläche der verbleibenden Folienbereiche und der mit Kupfer aufgefüllten Bereiche (12) wird durch chemisches Abscheiden von Kupfer eine dünne Leitschicht (14) aufgebracht,
e) auf diese Leitschicht (14) wird eine Photoresistfolie (15) aufgebracht und durch einen Photoprozess werden aus dieser Photoresistfolie (15) die Bereiche (16) abgetragen, die dem Innenleiter (6) der Signalleitung entsprechen,
f) diese Bereiche (16) werden mit galvanisch abgeschiedenem Kupfer aufgefüllt,
g) die verbleibende Photoresistfolie (15) wird abgestrippt,
h) die dabei offengelegte Leitschicht (14) wird durch eine Kupfer-Differenzätzung abgetragen, wobei der Innenleiter (6) von weiteren leitenden Bereichen (7,10) getrennt wird,
i) eine weitere photostrukturierbare Folie (18) wird auf die freigelegte Oberfläche auflaminiert,
j) diese Folie (18) wird in den Bereichen (19), die dem Außenleiter (7) der Signalleitung entsprechen, durch einen Photoprozeß abgetragen,
k) diese abgetragenen Bereiche (19) werden mit galvanisch abgeschiedenem Kupfer aufgefüllt,
l) auf die äußere Oberfläche der verbleibenden Folienbereiche und der mit Kupfer aufgefüllten Bereiche (19) wird durch chemisches Abscheiden von Kupfer eine dünne Leitschicht (20) aufgebracht, und
m) auf diese Leitschicht (20) wird galvanisch solange Kupfer abgeschieden, bis die erforderliche Außenleiter-Wandstärke der Signalleitung (1,2) erreicht ist.

2. Verfahren nach Anspruch 1, dadurch gekennzeichnet, daß als photostrukturierbare Folie (11,18) eine Permanentresist-Folie mit Endhärtung verwendet wird.

3. Verfahren nach Anspruch 1, dadurch gekennzeichnet, daß als photostrukturierbare Folie (11,18) eine Lötstoppresistfolie verwendet wird.

4. Verfahren nach Anspruch 1, dadurch gekennzeichnet, daß als metallisierte Trägerschicht eine mit Kupfer kaschierte Schicht aus einem glasfaserverstärkten Epoxid-Kunststoff verwendet wird.

## Claims

1. Method for producing a fully (all-round) shielded signal line (1, 2) for high-frequency circuits comprising the following steps:
    a) laminating a first photosensitive film (11) onto a metallized base layer (10),
    b) thereafter employing a photoprocess to remove this film (11) in the lower gaps (12) which correspond to the outer conductor (7) of the signal line,
    c) thereafter filling each of the said lower gaps (12) with copper by electrodeposition,
    d) thereafter chemically depositing a thin conductive layer (14) over the outer exposed surface of the remaining film areas and the lower gaps (12) filled with copper,
    e) thereafter applying a photoresist film (15) onto the said conductive layer (14), and subsequently employing a photoprocess to remove the areas (16) of this photoresist film (15) which correspond to the inner conductor (6) of the signal line,
    f) thereafter filling the said gap areas (16) with copper by electrodeposition,
    g) thereafter stripping away any remaining photoresist film (15).
    h) thereafter removing the thus-exposed conductive layer (14) by differential copper etching to thereby electrically isolate the inner conductor (6) from other conductive areas (7, 10),
    i) thereafter laminating a further photosensitive film (18) onto the exposed surface,
    j) thereafter removing this film (18) by means of a photoprocess in the areas (19) corresponding to the outer conductor (7) of the signal line,
    k) thereafter filling the thus-defined upper gaps (19) with copper by electrodeposition,
    l) thereafter chemically depositing a thin conductive layer (20) of copper over the outer upper surface of the remaining film areas and of the areas (19) filled with copper, and
    m) thereafter electrodepositing copper on this conductive layer (20) until the necessary wall thickness of the outer conductor of the signal line (1, 2) is obtained.

2. The process according to Claim 1, wherein a permanent resist film with final hardening is used as the photosensitive film (11, 18).

3. The process according to Claim 1, wherein a solderstop resist film is used as the photosensitive film (11, 18).

4. The process according to Claim 1, wherein said conductive base layer is supported on a copperclad substrate of fibreglass-reinforced epoxy plastic.

## Revendications

1. Procédé de fabrication d'une ligne de transmission (1,2) blindée de tous côtés pour circuits à haute fréquence, présentant les pas de procédé suivants:
    a) sur une couche porteuse métallisée (10) on rapporte par laminage une feuille (11) à structure modifiable par rayonnement lumineux,
    b) par un processus de photosensibilité, on enlève cette feuille (11) dans les zones (12) qui correspondent au conducteur extérieur (7) de la ligne de transmission,
    c) on remplit de cuivre, déposé par voie galvanique, ces zones enlevées (12),
    d) sur la surface extérieure des zones restantes de la feuille et des zones (12) remplies de cuivre, on rapporte, par dépôt chimique de cuivre, une fine couche conductrice (14),
    e) sur cette couche conductrice (14), on rapporte une feuille de résine photosensible (15) et, par un processus de photosensibilité, on enlève de cette feuille de résine photosensible (15), les zones (16) qui correspondent au conducteur intérieur (6) de la ligne de transmission,
    f) on remplit ces zones (16) de cuivre déposé par voie galvanique,
    g) par décomposition chimique, on enlève ce qui reste de la feuille de résine photosensible (15),
    h) on enlève la couche conductrice (14), ainsi exposée, par attaque chimique différentielle du cuivre, ce qui fait que le conducteur intérieur (6) se sépare des autres zones conductrices (7,10),
    i) sur la surface libérée , on rapporte, par laminage, une autre feuille (18) à structure modifiable par rayonnement lumineux,

j) par un processus de photosensibilité, on enlève cette feuille (18) dans les zones (19) qui correspondent au conducteur extérieur (7) de la ligne de transmission,

k) on remplit ces zones enlevées (19) de cuivre déposé par voie galvanique,

l) sur la surface extérieure des zones restantes de la feuille et des zones (19) remplies de cuivre, on rapporte, par dépôt chimique de cuivre, une mince couche conductrice (20), et

m) sur cette couche conductrice (20), on dépose, par voie galvanique, du cuivre, jusqu'à atteindre l'épaisseur de paroi nécessaire du conducteur extérieur de la ligne de transmission (1,2).

2. Procédé selon la revendication 1 , caractérisé par le fait que comme feuille (11,18) à structure modifiable par rayonnement lumineux, on emploie une feuille de résine photosensible à modification permanente à durcissement définitif.

3. Procédé selon la revendication 1 , caractérisé par le fait que comme feuille (11,18) à structure modifiable par rayonnement lumineux, on emploie une feuille de résine d'arrêt photosensible.

4. Procédé selon la revendication 1 , caractérisé par le fait que comme couche porteuse métallisée on emploie une couche de résine époxyde armée de fibres de verre, doublée de cuivre.

FIG.1

FIG.2A

FIG.2B
FIG.2C

FIG.2D

FIG.2E
FIG.2F

FIG.2G
FIG.2H

FIG.2I
FIG.2J
FIG.2K

FIG.2L
FIG.2M